Europäisches Patentamt

(19) European Patent Office

Office européen des brevets

(11) **EP 0 486 686 B2**

(12) **NEW EUROPEAN PATENT SPECIFICATION**

(45) Date of publication and mention
of the opposition decision:
**24.03.1999 Bulletin 1999/12**

(45) Mention of the grant of the patent:
**30.08.1995 Bulletin 1995/35**

(21) Application number: **88905427.6**

(22) Date of filing: **16.06.1988**

(51) Int. Cl.$^6$: **C01B 13/32**, C01G 3/00,
C04B 35/00, C04B 41/87,
H01L 39/12, H01L 39/24

(86) International application number:
**PCT/JP88/00585**

(87) International publication number:
**WO 88/10233 (29.12.1988 Gazette 1988/28)**

(54) **PROCESS FOR PRODUCING OXIDE SUPERCONDUCTORS**

VERFAHREN ZUR HERSTELLUNG VON SUPRALEITENDEN OXYDEN

PROCEDE DE PRODUCTION DES SUPRACONDUCTEURS A BASE D'OXYDE

(84) Designated Contracting States:
**DE FR GB NL**

(30) Priority: **17.06.1987 JP 150784/87**
**24.11.1987 JP 293950/87**
**20.01.1988 JP 8473/88**
**08.02.1988 JP 25605/88**
**03.06.1988 JP 135653/88**
**03.06.1988 JP 135654/88**
**03.06.1988 JP 135655/88**

(43) Date of publication of application:
**27.05.1992 Bulletin 1992/22**

(60) Divisional application:
**93117398.3 / 0 587 198**

(73) Proprietor:
**Nippon Telegraph and Telephone Corporation**
**Tokyo 100 (JP)**

(72) Inventors:
• **SHIBATA, Shuichi**
**Ibaraki 310 (JP)**
• **KITAGAWA, Takeshi**
**Ibaraki 310 (JP)**
• **OKAZAKI, Hisaaki**
**Ibaraki 310 (JP)**
• **KIMURA, Takao**
**Ibaraki 310 (JP)**
• **HORIGUCHI, Masaharu**
**Ibaraki 311-02 (JP)**

(74) Representative:
**Bühling, Gerhard, Dipl.-Chem. et al**
**Patentanwaltsbüro**
**Tiedtke-Bühling-Kinne & Partner**
**Bavariaring 4**
**80336 München (DE)**

(56) References cited:
**WO-A-88/08609** **JP-A-61 194 786**
**JP-A-63 139 006**

• **Japanese Journal of Applied Physics, vol. 27,
no. 1, January 1988, P. L53-L54**
• **Japanese Journal of Applied Physics, vol. 27,
no. 4, April 1988, p. L646-648**
• **Japanese Journal of Applied Physics, vol. 27,
no. 5, May 1988, p. L867-869**
• **S. Adochi et al., Japanese Journal of Applied
Physics 27, No. 3, L. 344-346 (March 1988)**
• **N.-L. Wu et al., Materials Letters 6, No. 7, 211-
216, April 1988**
• **Y. Takagi et al., Japanese Journal of Applied
Physics 26, No. 8, L. 1266-L.1267 (August 87)**
• **N. L. Wu et al., Materials, Letters 5, No. 11, 12,
432-435 (October 1987)**

Remarks:
The file contains technical information submitted
after the application was filed and not included in
this specification

EP 0 486 686 B2

**Description**

The present invention relates to a process for preparing high temperature superconducting oxide ceramics.

The present invention particularly relates to processes for producing c-axis oriented superconducting film and bulk materials.

Recently, superconducting oxide ceramics which shows superconductivity at or above the liquid nitrogen temperature have been found. For example, $YBa_2Cu_3O_{7-x}$ and $LnBa_2Cu_3O_{7-x}$ (Ln:a lanthanoid) are reported as superconductors having a superconducting transition temperature $(T_c)$ at about 90K. These high-$T_c$ superconducting oxides are favorable for wide commercial application, because the price of liquid nitrogen used for a cooling medium is about 1/10 of that of liquid helium. These superconductors are fabricated from oxide powders as starting materials. Since the properties of the superconductors themselves are strongly influenced by the starting materials, not only the fabrication process of superconductors but also the producing method of starting oxide powders are widely investigated.

The post-published WO88/08609 discloses a process for preparing a superconducting oxide ceramic comprising the steps of preparing an oxide powder having a composition of, for example, $YBa_2Cu_3O_{6.5}$ or $YBa_2Cu_2NiO_{6.5}$, sintering the oxide powder, then grinding the powder, and finally pressing the powder into a pellet at about $1.69 \cdot 10^8 Pa$.

The post-published WO88/10009 further discloses the use of, for example, $Bi_2Sr_2CaCu_2O_{8+y}$ as a starting material in a process for preparing a a superconducting oxide ceramic.

Meanwhile, for forming a superconducting film, various techniques have been investigated; method using a reaction in gas phase such as a plasma spray coating technique, a vacuum evaporation technique and a sputtering technique, and coating method such as a screen printing technique, a spin coating technique. These techniques involve a heating process after the formation of a film on a substrate, and have some problems. In the vacuum evaporation and the sputtering techniques, the composition of the film is often different from the starting material composition. Furthermore, in the sputtering process, crystal structure and orientation of the resultant film is strongly influenced by the substrate temperature. The screen printing technique also has such a problem that a dense film cannot be obtained easily because of a large particle size of starting powder, and that a critical current density of the film made by this technique is lower than that of a film formed by the sputtering. Another technique for producing superconducting film is proposed; organometallic compounds such as yttrium stearate, barium naphthenate and copper naphthenate dissolved into a suitable solvent is coated on a substrate and heated to decompose into oxide film. This technique also has a problem that carbon is remained in the film because of the strong reducing atmosphere in the sintering process.

For practical application of the superconducting material, high critical current density and high critical magnetic field should be secured. It is known that if the superconducting crystal is c-axis oriented and a current is flowed along a surface perpendicular to the c-axis, critical current density is improved. Therefore, it is desirable that superconducting crystal has a particular orientation. Although, when the $YBa_2Cu_3O_x$ powder is pressed into pellet shape, c-axis orientation is observed, no method is reported to realize c-axis orientation effectively.

DISCLOSURE OF THE INVENTION

An object of the present invention is to provide a process for forming a superconducting oxide film or bulk products having a high degree of c-axis orientation.

In the present invention, a process for preparing a superconducting oxide comprises the steps of:

preparing an oxide powder having a particular composition as specified below;
sintering the oxide powder to develop a superconducting phase;
grinding the resulting sinter into a fine powder;
and
pressing the fine powder to develop c-axis orientation in a direction parallel with the pressing direction.

In a first aspect of the present invention, the oxide powder has a composition within a range: $Ln/(Ln + Ae + Cu) < 16.6$ mol %, $Cu/(Ln + Ae + Cu) > 50$ mol % and Ae = the balance (wherein Ln is yttrium or at least one lanthanoid and Ae is at least one alkali earth metal).

In the second aspect of the invention, the oxide powder has a composition within a range: $Bi/(Bi + Ae + Cu) = 5 - 40$ mol %, $Ae/(Bi + Ae + Cu) = 15 - 70$ mol % and $Cu/(Bi + Ae + Cu) = 24 - 64$ mol % - (wherein Ae is at least one alkali earth metal).

In this case, pressing is carried out at a pressure of not less than $9.81 \cdot 10^8$ Pa (10000 kg/cm$^2$).

Fig. 1 shows X-ray diffraction patterns for the powder samples made from the orientation composition and the 1-2-3 composition, respectively;
Fig. 2 is a schematic view illustrating the c-axis orienting by pressing;

Fig. 3 shows relationships between the degree of c-axis orientation peak ratio of (006)/(110)(103)) and the applied pressure;

Fig. 4 shows the compositions from which highly orientation easily obtained by pressing;

Fig. 5 shows relationships between the orientation (peak ratio of (006)/(110)(103)) and the applied pressure;

Fig. 6 shows starting compositions in a Bi-Sr-Ca-Cu-O system;

Fig. 7 shows an X-ray diffraction pattern for c-axis-oriented $BiSrCaCu_3O_x$ powder sample;

Fig. 8 shows X-ray diffraction patterns for the samples made by pressing at different pressures; and

Fig. 9 shows relationships between the orientation (presented by peak ratio (008)/$2\theta = 27.5°$) and the applied pressure.

For preparing superconducting powder, alkoxides are dissolved into solvents and mixed. Then, they are hydrolyzed and dried.

Since the raw materials are dissolved into the solvent and hydrolyzed into fine complex oxide particles in a liquid phase, the resultant particles are very small in size and homogeneous. Thus, these powders prepared in the process of the invention have higher activity for sintering than those made by a conventional processes and are obtained by reaction at lower temperature.

An alkoxides $M(OR)_n$ (where M is metal, OR is an alkoxyl group and n is valence state of metal M) is hydrolyzed by water into metallic oxides (or their hydrates) and an alcohol, as shown in the following reaction formula.

$$M(OR)_n + nH_2O \rightarrow M(OH)_n + nROH$$

$$mM(OH)_n \rightarrow mMO_{n/2} + mn/2\ H_2O$$

If two or three alkoxides are hydrolyzed simultaneously, fine double or triple complex oxide particles can be formed at a temperature below the boiling point of the solvent.

Generally, the powders prepared by hydrolysis of alkoxides have small size of 0.001 to 0.01 $\mu$m. It means that the powder has a large surface energy and shows a good packing ability. Therefore, a dense product can be obtained by sintering at relatively low temperature.

The step of preparing the oxide powder in the process of the present invention will be presented below in detail: (1) preparation of solution, (2) hydrolysis, (3) aging and (4) drying processes.

(1) Preparation of Solution

Since, in general, alkoxides of copper, barium, yttrium and lanthanoid are all solids at room temperature, solubility of the alkoxides into organic solvents is one of the key point in selection. If the solubility of the alkoxide is very low, an enormous amount of solvent is necessary to hydrolyze and polymerize uniformly, which means it far from the economical application. The solubilities of alkoxide powders into 1 liter of various solvents are determined by the experiments (Table 1).

Table 1

| Solubilities of Alkoxide Powders | | |
|---|---|---|
| Alkoxide | Solvent | Solubility (g) in 1 $\ell$ of Solvent (20°C) |
| $Cu(OCH_3)_2$ | $CH_3OH$ | 10 |
| $Cu(OC_2H_5)_2$ | $C_2H_5OH$ | 12 |
| $Cu(i\text{-}OC_3H_7)_2$ | $i\text{-}C_3H_7OH$ | 15 |
| $Ba(OCH_3)_2$ | $CH_3OH$ | 0.04 |
| $Ba(OC_2H_5)_2$ | $C_2H_5OH$ | 0.07 |
| $Ba(i\text{-}OC_3H_7)_2$ | $i\text{-}C_3H_7OH$ | 0.09 |
| $Y(OCH_3)_3$ | $CH_3OH$ | 0.01 |
| $Y(OC_2H_5)_3$ | $C_2H_5OH$ | 0.01 |
| $Y(i\text{-}OC_3H_7)_3$ | $i\text{-}C_3H_7OH$ | 0.02 |

As shown in Table 1, the solubilities of barium and yttrium alkoxides in 1 liter solvents are several ten mg order; which is one hundredth of that of copper alkoxides. The solubilities of lanthanoids are the same order as those of yttrium alkoxides. These results indicate that it is unpractical to use a dried powder alkoxides of barium, yttrium or lanthanoids as starting materials because of their low solubilities.

Nevertheless, it was found in the experiment that alkoxides can be dissolved in a solvent just after the synthesis. For example, barium alkoxide, which can be obtained by a direct reaction of metallic barium with an alcohol using an reflux technique as shown in the following reaction formula, can be dissolved several tens of grams in 1 liter alcohol solvent before cooling.

$$Ba + 2ROH \rightarrow Ba\,(OR)_2 + H_2$$

Yttrium or lanthanoid alkoxides which can be synthesized by an exchange reaction of yttrium or lanthanoid chlorides with a sodium alkoxide using reflux technique in an alcohol solvent (given in the following reaction formula), are also dissolved several grams in 1 liter alcohol solvent before cooling.

$$YCl_3 + 3NaOR \rightarrow Y(OR)_3 + 3NaCl$$

$$LnCl_3 + 3NaOR \rightarrow Ln(OR)_3 + 3NaCl$$

Although it is not yet clear about these phenomena, if, after synthesizing, barium, yttrium or lanthanoid alkoxides is used immediately, completely dissolved alkoxides are available for the next reaction. It should be noted that in order to avoid cooling, the alkoxide solutions must be treated immediately after synthesizing. An alcoholic solution containing two equivalents of barium alkoxide is mixed with an solution containing one equivalent of yttrium alkoxide with no cooling. And then, three equivalent of copper alkoxide solution is added with vigorous stirring. Thus starting solution is obtained. For instance, 0.01 mole $YBa_2Cu_3O_x$ can be dissolved in 1 liter solvent when isopropanol and isopropoxides are used as solvent and alkoxides, respectively.

It is more desirable that the starting solution involving alkoxides should be refluxed more than 10 minutes. The refluxing make a chance for dispersed. alkoxides to meet one another in solution and enables them to make a polynuclear complex or multialkoxides which have similar coordination state as that of the oxides. Oxide powder of multicomponent single phase can be obtained through hydrolysis of polynuclear complexes or multialkoxides.

It is also preferable that reflux in alkoxide synthesizing and mixing is carried out under dry atmosphere not to hydrolyze with moisture in air.

(2) Hydrolysis.

In hydrolysis, large amount of water is untolerable, because water-soluble hydroxides is formed and from which copper or barium oxides are generated during drying and heating processes.

Deionized water with high purity should be used, because dissociation of copper or barium from the complex compounds is caused by impurities such as chlorine ion in water and hence the change of the compositions is brought. Furthermore, water diluted with the solvent is recommended for uniform hydrolysis reaction.

(3) Aging

The dried powder, which was obtained from the solution just after hydrolysis, has a small particle size and a high surface activity. Thus, the powder has several problems such that: (1) low crystallinity, (2) primary particles easily aggregate, (3) remarkable adsorption of water on particle surface in air, (4) abnormal grain growth and bubble formation in sintering process. To avoid these problems, powders with 0.01 to 0.1 $\mu$m in diameter can be prepared by refluxing or holding a solution at a temperature close to the boiling point of the solvent after hydrolysis. A partially dried or condensed solution after aging is close to gel state, and in it, copper, barium and yttrium exist almostly oxide from with a size of less than 1 $\mu$m. These process for preparing the starting materials is named sol-gel method.

(4) Drying

Available drying methods are; keeping the suspension involved fine particles at a temperature lower than the boiling point of the solvent, or under reduced pressure for evaporating the solvent, and spraying the suspension into small droplet form and dried rapidly in hot air.

The powders, produced as described above, have a size of 1 $\mu$m or less and a single phase for superconducting oxides. Thus, they can be sintered at a temperature lower than that of the conventional processes.

The present invention will be described in detail in the following examples.

Particularly, processes for preparing a c-axis-oriented bulk sample will be described below. By using a pressing technique of superconducting oxides, a bulk sample which is c-axis-oriented parallel to the pressing direction can be produced.

Example 1

Reagents $Y_2O_3$, $BaCO_3$ and $CuO$ were mixed to make two types of compounds with different compositions; one is Y:Ba:Cu = 1:2:3 (called as 1-2-3 composition) (Y = 16.7 mole %, Ba = 33.3 mole % and Cu = 50.0 mole %) and the other is a composition of Y = 8 mole %, Ba = 30 mole %, Cu = 62 mole % (called as orientation composition). The mixtures were pre-sintered at 950°C for 5 hours in an oxygen atmosphere and ground to make powder samples.

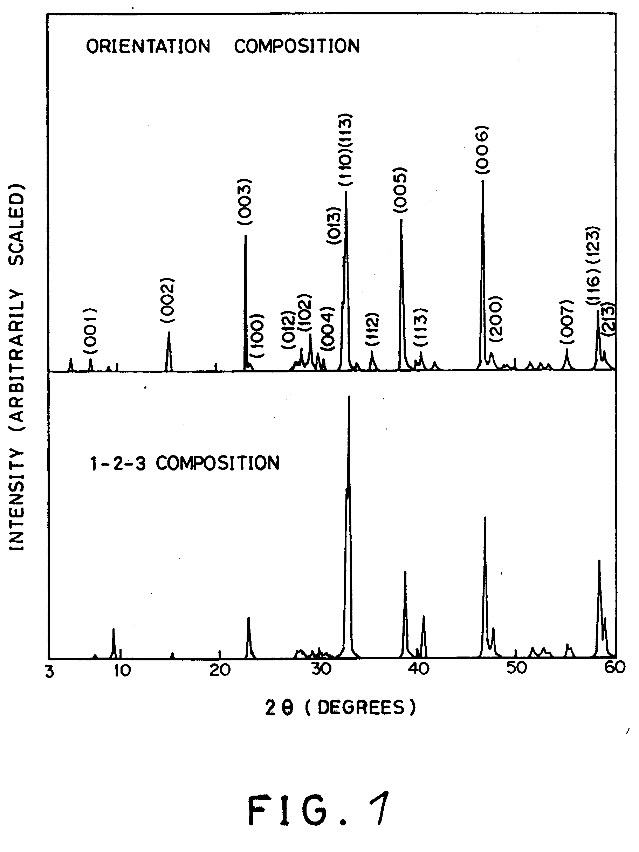

X-ray diffraction patterns for the sample with the compositions of the orientation and the 1-2-3 are shown in Fig. 1. The degree of the orientation can be estimated roughly by comparing intensities of the (00N) peaks (N is an integer) and the other peaks, for example, (006)/(110)(103). The peak ratios of R =-(006)/(110 (103) were 1.06 for the sample of the orientation composition and 0.52 for that of the 1-2-3 composition.

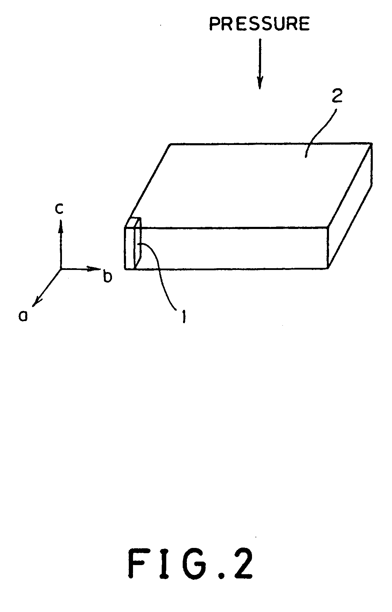

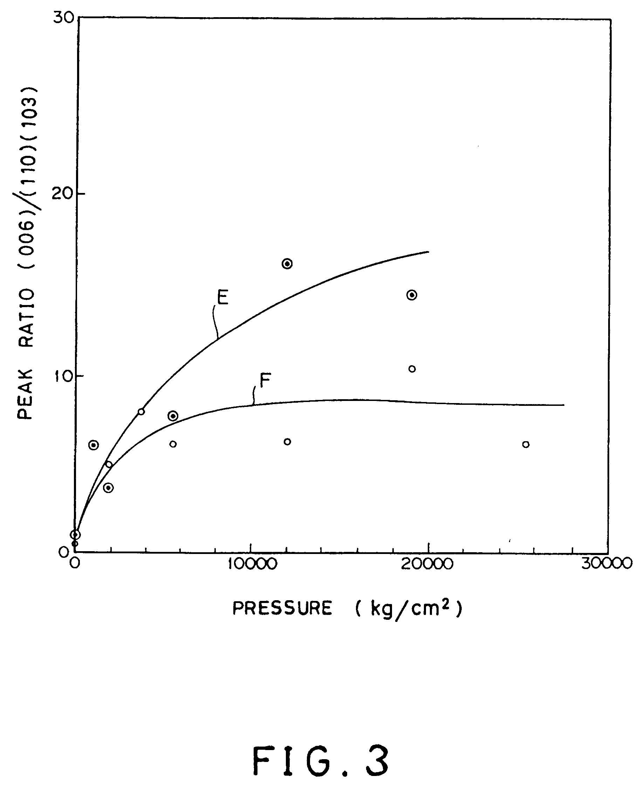

The two kinds of composition powders were pressed into pellets with various pressures and examined by X-ray diffraction. The direction of the pressure is parallel with the c-axis as shown in Fig. 2. In Fig. 3, the degrees of the orientation (estimated by (006)/(110)(103) peak ratio) are plotted against applied pressure. Curve E shows the peak ratios for the pellet samples made from the powder with the orientation composition, and curve F shows those for the sample from the powder with the 1-2-3 composition. The powder with the orientation composition shows higher orientation than that with the 1-2-3 composition.

The powder sample with the orientation composition contain a large amount of plate-like crystals which can be easily oriented by pressing. Thus, after pressing, the sample shows an excellent degree of the orientation.

As shown schematically in Fig. 2, since a unit cell 1 with a, b, and c axis (a = 3.8181 Å, b = 3.888 Å, c = 11.688 Å) forms a plate-like crystal 2, these plate-like crystals are easily arranged by pressing to stabilize them against applied pressure.

Example 2

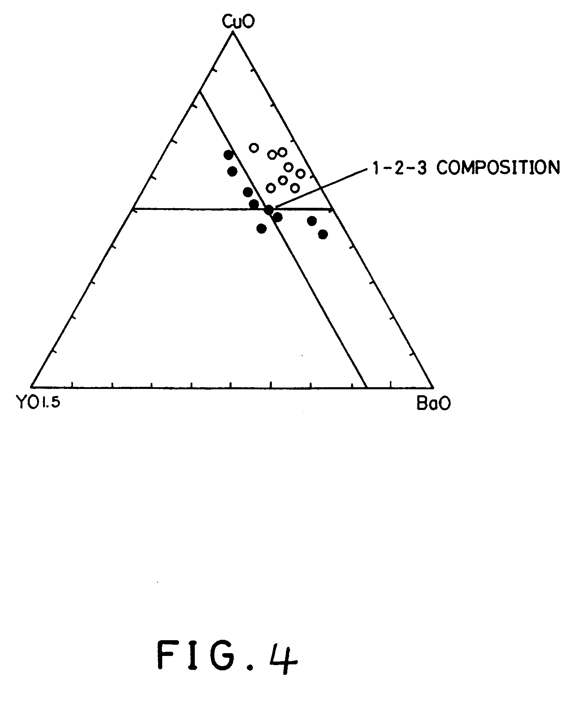

In Y-Ba-Cu-O system, compositions were changed to attain a high orientation by pressing. Mixtures of the reagents were sintered at 950°C in an oxygen atmosphere (the same condition in the example 1). Pellets were made by pressing of $1.864 \cdot 10^9$ Pa (19000 kg/cm$^2$). The results are shown in Fig. 4. In the ternary system graph, open circles stand for the samples which show the same order of orientation as that of the orientation composition, and closed circles for the samples which shows the same order of orientation as that of the 1-2-3 composition or less than that. The composition region of open circles (high orientation region) agrees well with that in the oriented film.

The high orientation region is Y/(Y + Ba + Cu)<16.6 mole % and Cu/(Y + Ba + Cu)>50 mole %, which is located to Y-poor and Cu-rich side.

Example 3

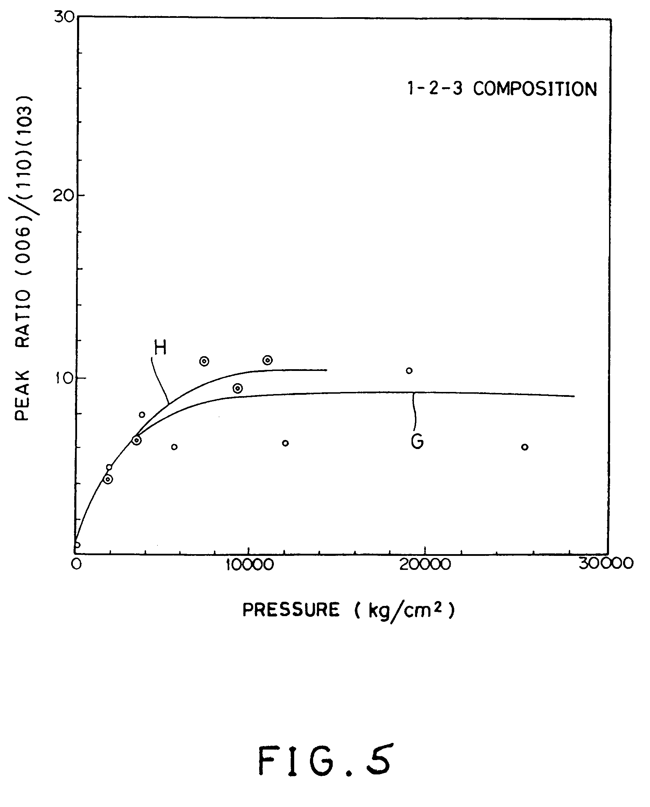

The powder samples with the 1-2-3 composition are pressed into pellets at various pressures and are resintered at 875°C for 40 hours in an oxygen atmosphere. The pellets are checked by X-ray diffraction. The peak ratios of (006)/(110)(103) in the 1-2-3 composition samples are plotted against pressures in pressing process. Curve G of Fig. 5 shows the degrees for the samples subjected to only pressing, and curve H those for the samples subjected to pressing and re-sintering at 875°C. No noticeable change in the degrees of orientation were not observed after re-sintering at that temperature. Although the results in the samples with the orientation composition are not shown here, but almost the same results are obtained; no decrease was observed after re-sintering at 875°C.

Electrical resistances of the re-sintered pellet samples were measured by a conventional four-probe technique. The onset temperature was 93 K, and the zero resistance temperature was 90 K.

In this example, re-sintering was carried out to ensure the mechanical strength against thermal shock in this measurement.

Reference Example 4

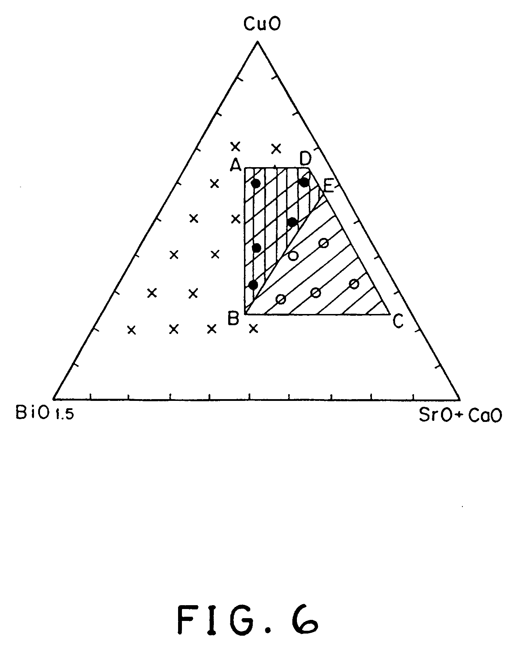

Reagents of $Bi_2O_3$, $SrCO_3$, $CaCO_3$ and $CuO$ were mixed to make a various compositions respectively shown by open circles, closed circles and crosses in Fig. 6, and pre-sintered at 875 °C for 10 hours in a platinum boat in an oxygen atmosphere. The sintered samples were ground into powders. Then, using a pressing plate, the powders were pressed on the sample plate by a vertical pressure of $9.81 \cdot 10^4$ Pa (1 kg/cm$^2$) or less and X-ray diffraction patters

5

(CuKα) were measured.

The compositions in the region surrounded by B-C-E lines in Fig. 6 showed superconducting phases but did not show an high orientation.

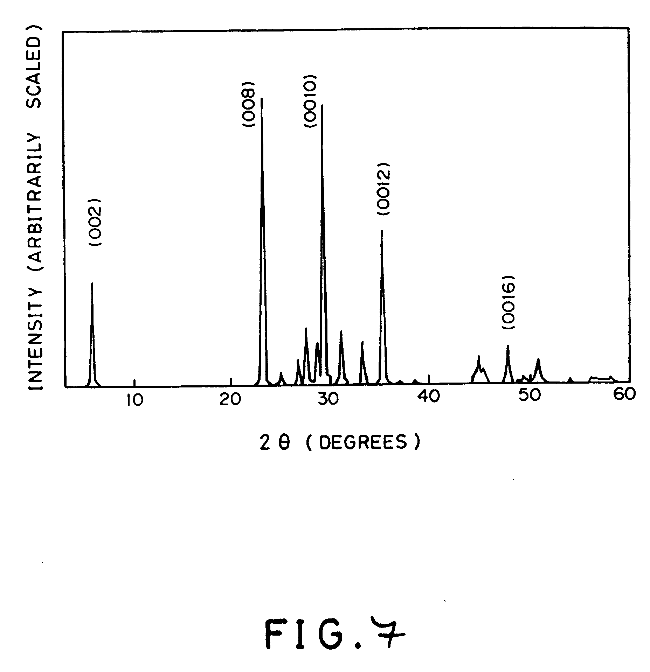

X-ray diffraction pattern for the sample of $BiSrCaCu_2O_x$ is shown in Fig. 7. In this diffraction pattern, (00N) peaks show higher intensities than the other peaks even at a pressure of $9.81 \cdot 10^4$ Pa ($1$ kg/cm$^2$) or less. Thus, the composition $BiSrCaCu_3O_x$ has a tendency to be highly c-axis oriented. In this diffraction pattern, the strong peak is appeared at $2\theta = 5.8°$. The $5.8°$ peak is commonly observed in the compositions within the region surrounded by A-B-E-D lines. The samples which are shown as closed circles in Fig. 6, composition region surrounded by A-B-E-D lines, also show a superconductivity and an high orientation in making a oriented bulk sample by pressing. However, in the compositions indicated by crosses no peak was appeared at $2\theta = 5.8°$, hence these compositions is not superconducting phase.

In the cases of compositions, SrO:CaO = 1:3 and SrO:CaO = 3:1 the obtained results were similar to that described above.

An adequate amount of propylene glycol was added to the mixed and not pre-sintered powders having various compositions shown in Fig. 6 to make pastes. Resultant pastes were coated on YSZ substrates and examined by X-ray diffraction. The samples with compositions in the region surrounded by A-B-E-D lines showed a high orientation when films were made from them. Accordingly, it can be said that the compositions surrounded by A-B-E-D lines, compositions of Cu or Bi-rich, are suitable for making a c-axis oriented sample in both of film and bulk.

Example 5

Reagents of $Bi_2O_3$, $SrCO_3$, $CaCO_3$ and CuO were mixed in a mole ratio of $Bi_2Sr_{1.5}Ca_{1.5}Cu_2O_x$ and presintered at 875°C for 10 hours in a platinum boat in an oxygen atmosphere. The samples were ground into powders and pressed into pellets at various pressures to examine a pressure dependency of the degree of the orientation.

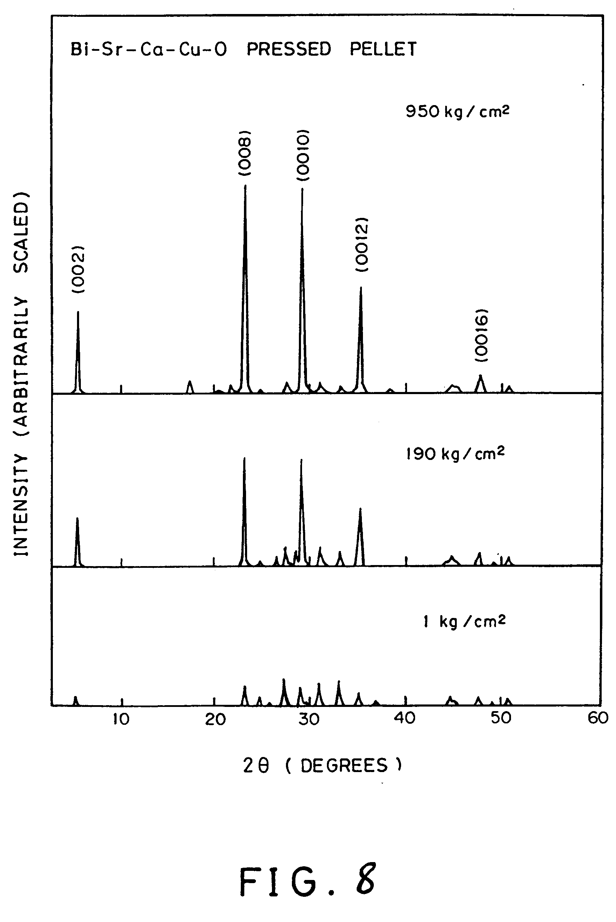

X-ray,diffraction patters for these samples are shown in Fig. 8. At a pressure of $9.81 \cdot 10^4$ Pa ($1$ kg/cm$^2$) or less, no orientation was observed. At $1.864 \cdot 10^7$ Pa ($190$ kg/cm$^2$), c-axis orientation was observed, and at $9.3195 \cdot 10^7$ Pa ($950$ kg/cm$^2$) the degree of the orientation was enhanced.

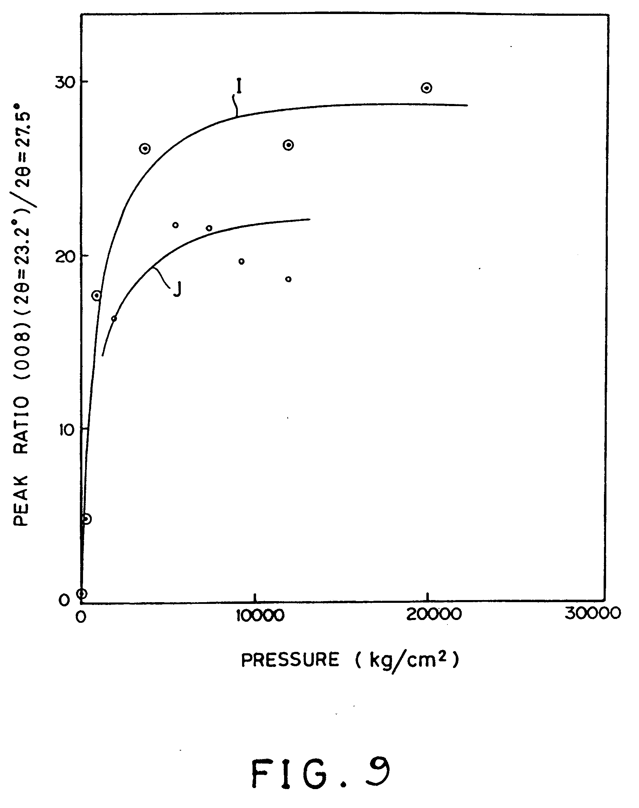

Peak ratios of $(008)(2\theta = 23.2°)/2\theta = 27.5°$ are plotted against pressure in Fig. 9. As shown in curve I, the peak ratio increased with increasing pressure and reached a constant value 28 at $9.81 \cdot 10^8$ Pa ($10000$ kg/cm$^2$) pressure. In Fig. 9, curve J shows peak ratio of sample which is re-sintered at 850°C for 40 hours in air after pressing: Sintering is often necessary for using superconducting powders. From comparison with curve I, it is seen that although by re-sintering degree of orientation is slightly decreased the pressure dependency was almost same.

Electrical resistance vs temperature curves of these samples were such that the resistance decreased with decreasing temperature. At 110 K, a slight change of resistance was observed, and the onset and zero resistance temperatures were 88 K and 83 K, respectively.

The Bi-Sr-Ca-Cu-O samples is known to have two superconducting phases of 110 K and 80 K. In this example, the sample showed a 80 K-class superconducting property.

Reference Example 6

Alkoxides, $Bi(n-OC_4H_9)_3$, $Sr(n-OC_4H_9)_2$, $Ca(i-OC_3H_7)_2$ and $Cu(i-OC_3H_7)_2$, were mixed in a mole ratio of Bi:Sr:Ca:Cu = 2:1.5:1.5:2 in 1-butanol solvent. The solution was refluxed for 20 hours and 5 to 10 times pure water to total mole of Bi, Sr, Ca, Cu was titrated into it with ultrasonic vibration. Then, the solution was refluxed again for 10 hours to ensure the complete hydrolysis. The oxide powder sample was obtained by drying the solution.

The powder was pre-sintered at 800°C for 10 hours, and ground into powder again. The resultant powder was pressed into pellet at a pressure of $3.924 \cdot 10^5$ Pa ($4000$ kg/cm$^2$) and examined by X-ray diffraction.

The peak ratio of $2\theta = 23.2°/2\theta = 27.5$ was about 30. The degree of the orientation was slightly higher than that in the example 5.

As described above, highly c-axis oriented superconducting film and bulk products can be fabricated from the compounds with the starting compositions of Cu>50 mole % and Ln<16.6 mole % in Ln-Ae-Cu-O system.

Highly c-axis-oriented superconducting film and bulk products can be further fabricated from the compounds with the starting compositions of Bi/(Bi + Ae + Cu) = 5-40 mole %, Ae/(Bi + Ae + Cu) = 15-70 mole %, Cu/(Bi + Ae + Cu) = 24-64 mole %, and more preferably the starting compositions of Bi/(Bi + Ae + Cu) = 5- 40 mole %, Ae/(Bi + Ae + Cu) = 15-40 mole %, Cu/(Bi + Ae + Cu) = 24-64 mole %. c-axis oriented products are advantageous for superconducting film and bulk in terms of high critical current density.

**Claims**

1. A process for preparing a superconducting oxide, characterized by comprising the steps of:

 preparing an oxide powder having a composition within a range: $Ln/(Ln + Ae + Cu) < 16.6$ mol %, $Cu/(Ln + Ae + Cu) > 50$ mol % and Ae = the balance (wherein Ln is yttrium or at least one lanthanoid and Ae is at least one alkali earth metal);
 sintering the oxide powder to develop a superconducting phase;
 grinding the resulting sinter into a fine powder; and
 pressing said fine powder to develop c-axis orientation in a direction parallel with the pressing direction.

2. A process for preparing a superconducting oxide as claimed in claim 1, characterized in that said Ln is yttrium and said Ae is barium.

3. A process for preparing a superconducting oxide, characterized by comprising the steps of:

 preparing an oxide powder having a composition within a range: $Bi/(Bi + Ae + Cu) = 5 - 40$ mol %, $Ae/(Bi + Ae + Cu) = 15 - 70$ mol % and $Cu/(Bi + Ae + Cu) = 24 - 64$ mol % (wherein Ae is at least one alkali earth metal);
 sintering the oxide powder to develop a superconducting phase;
 grinding the resulting sinter into a fine powder; and
 pressing said fine powder at a pressure of not less than $9.81 \cdot 10^8$ Pa ($10000$ kg/cm$^2$) to develop c-axis orientation in a direction parallel with the pressing direction.

4. A process for preparing a superconducting oxide as claimed in claim 3, characterized in that said Ae is strontium, calcium or a mixture thereof.

5. A process for preparing a superconducting oxide as claimed in claim 3 or claim 4, **characterized** i**n** that said oxide powder has a composition of $Bi/(Bi + Ae + Cu) = 5 - 40$ mol %, $Ae/(Bi + Ae + Cu) = 15 - 40$ mol % and $Cu/(Bi + Ae + Cu) = 24 - 64$ mol %.

**Patentansprüche**

1. Verfahren zur Herstellung eines supraleitenden Oxids, dadurch gekennzeichnet, daß es die folgenden Schritte umfaßt:

 Herstellen eines Oxidpulvers mit einer Zusammensetzung, die in folgendem Bereich liegt: $Ln/(Ln + Ae + Cu) < 16,6$ Mol%, $Cu/(Ln + Ae + Cu) > 50$ Mol% und Ae = Rest (wobei Ln Yttrium oder mindestens ein Lanthanoid ist und Ae mindestens ein Erdalkalimetall ist);

 Sintern des Oxidpulvers zum Entwickeln einer supraleitenden Phase;

 Mahlen des resultierenden Sintergutes zu einem feinen Pulver und

 Fressen des erwähnten feinen Pulvers zum Entwickeln einer Orientierung der c-Achse in einer zu der Preßrichtung parallelen Richtung.

2. Verfahren zur Herstellung eines supraleitenden Oxids nach Anspruch 1, dadurch gekennzeichnet, daß das erwähnte Ln Yttrium ist und das erwähnte Ae Barium ist.

3. Verfahren zur Herstellung eines supraleitenden Oxids, dadurch gekennzeichnet, daß es die folgenden Schritte umfaßt:

 Herstellen eines Oxidpulvers mit einer Zusammensetzung, die in folgendem Bereich liegt: $Bi/(Bi + Ae + Cu) = 5$ bis $40$ Mol%, $Ae/(Bi + Ae + Cu) = 15$ bis $70$ Mol% und $Cu/(Bi + Ae + Cu) = 24$ bis $64$ Mol% (wobei Ae mindestens ein Erdalkalimetall ist);

 Sintern des Oxidpulvers zum Entwickeln einer supraleitenden Phase;

Mahlen des resultierenden Sintergutes zu einem feinen Pulver und Pressen des erwähnten feinen Pulvers unter einem Druck von nicht weniger als $9{,}81 \cdot 10^8$ Pa (10.000 kg/cm$^2$) zum Entwickeln einer Orientierung der c-Achse in einer zu der Preßrichtung parallelen Richtung.

4.  Verfahren zur Herstellung eines supraleitenden Oxids nach Anspruch 3, dadurch gekennzeichnet, daß das erwähnte Ae Strontium, Calcium oder eine Mischung davon ist.

5.  Verfahren zur Herstellung eines supraleitenden Oxids nach Anspruch 3 oder Anspruch 4, dadurch gekennzeichnet, daß das erwähnte Oxidpulver eine Zusammensetzung von Bi/(Bi + Ae + Cu) = 5 bis 40 Mol%, Ae/(Bi + Ae + Cu) = 15 bis 40 Mol% und Cu/(Bi + Ae + Cu) = 24 bis 64 Mol% hat.

**Revendications**

1.  Procédé de préparation d'un oxyde supraconducteur, caractérisé en ce qu'il consiste :

    à préparer une poudre d'oxyde ayant une composition comprise dans l'intervalle : Ln/(Ln + Ae + Cu) < 16,6 % en mole , Cu/(Ln + Ae + Cu) > 50 % en mole et Ae = le solde (Ln est l'yttrium ou au moins un lanthanoïde et Ae est au moins un métal alcalino-terreux) ;
    à fritter la poudre d'oxyde pour faire apparaître une phase supraconductrice ;
    à broyer le fritté obtenu en une poudre fine ; et
    à comprimer la poudre fine pour faire apparaître une orientation d'axe c dans une direction parallèle à la direction de compression.

2.  Procédé de préparation d'un oxyde supraconducteur suivant la revendication 1, caractérisé en que Ln est l'yttrium et Ae est le baryum.

3.  Procédé de préparation d'un oxyde supraconducteur, caractérisé en ce qu'il consiste :

    à préparer une poudre d'oxyde ayant une composition comprise dans l'intervalle : Bi/(Bi + Ae + Cu) = 5 à 40 % en mole , Ae/(Bi + Ae + Cu) = 15 à 70 % en mole et Cu/(Bi et Ae + Cu) = 24 à 64 % en mole (dans laquelle Ae est au moins un métal alcalino-terreux) ;
    à fritter la poudre d'oxyde pour faire apparaître une phase supraconductrice ;
    à broyer le fritté obtenu en une poudre fine ; et
    à comprimer la poudre fine sous une pression qui n'est pas inférieure à $9{,}81 \cdot 10^8$ Pa (10.000 Kg/cm$^2$) pour faire apparaître une orientation d'axe c dans une direction parallèle à la direction de compression.

4.  Procédé de préparation d'un oxyde supraconducteur suivant la revendication 3, caractérisé en ce que Ae est le strontium, le calcium ou leurs mélanges.

5.  Procédé de préparation d'un oxyde supraconducteur suivant la revendication 3 ou la revendication 4, caractérisé en ce que la poudre d'oxyde a une composition comprise dans l'intervalle : Bi/(Bi + Ae + Cu) = 5 à 40 % en mole , Ae/(Bi + Ae + Cu) = 15 à 40 % en mole et Cu/(Bi + Ae + Cu) = 24 à 64 % en mole .

FIG. 1

PRESSURE

2

c

b

a

1

# FIG.2

# FIG.3

# FIG.4

FIG.5

FIG. 6

FIG.7

FIG. 8

FIG. 9